Europäisches Patentamt

European Patent Office

Office européen des brevets

(19)

(11) **EP 0 877 487 B1**

(12) **FASCICULE DE BREVET EUROPEEN**

(45) Date de publication et mention
de la délivrance du brevet:
**05.07.2000 Bulletin 2000/27**

(51) Int Cl.⁷: **H03L 7/197**

(21) Numéro de dépôt: **98401089.2**

(22) Date de dépôt: **05.05.1998**

(54) **Synthétiseur de fréquence cohérent à boucle de phase et pas fractionnaires**

Kohärenter, Fraktional-N-Frequenzsynthetisierer mit einer Phasenregelschleife

Coherent, fractional-N phase locked loop frequency synthesizer

(84) Etats contractants désignés:
**DE FR GB IT NL SE**

(30) Priorité: **07.05.1997 FR 9705625**

(43) Date de publication de la demande:
**11.11.1998 Bulletin 1998/46**

(73) Titulaire: **THOMSON-CSF**
**75008 Paris (FR)**

(72) Inventeurs:
• **de Gouy, Jean-Luc, Thomson-CSF Prop. Intel.**
**94117 Arcueil Cedex (FR)**
• **Gabet, Pascal, Thomson-CSF Propriete Intel.**
**94117 Arcueil Cedex (FR)**

(74) Mandataire: **Beylot, Jacques et al**
**Thomson-CSF Propriété Intellectuelle,**
**13, Avenue du Président Salvador Allende**
**94117 Arcueil Cédex (FR)**

(56) Documents cités:
**EP-A- 0 218 508        EP-A- 0 557 799**
**FR-A- 2 426 358        US-A- 4 468 632**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

EP 0 877 487 B1

## Description

La présente invention concerne la synthèse de fréquence et plus particulièrement les synthétiseurs de fréquence à boucle de phase et pas fractionnaires.

Dans de nombreux domaines, il est nécessaire d'engendrer des trains d'ondes de fréquences différentes tout en conservant une cohérence de phase entre les trains d'ondes de même fréquence, c'est-à-dire un même décalage de phase par rapport à un signal pilote, par exemple pour pouvoir en suivre l'historique Doppler.

Un synthétiseur de fréquence à boucle de phase se compose d'un oscillateur commandé en tension asservi en phase sur un oscillateur de référence au moyen d'une boucle de phase comparant une sous-harmonique du signal de sortie de l'oscillateur commandé en tension obtenue par division entière ou fractionnaire, au signal de l'oscillateur de référence. La division se fait au moyen d'un compteur-diviseur à rang de division entier mis à jour à chaque débordement, ce qui entraîne que le début d'un train d'ondes est toujours synchronisé avec un débordement du compteur-diviseur qui lui-même se produit au cours d'une période du signal de l'oscillateur de référence. Le manque de cohérence apparaît pour un rapport de division fractionnaire car alors, les débordements du compteur-diviseur se produisent, par rapport aux périodes du signal de l'oscillateur de référence, avec un décalage de phase qui évolue sur une durée égale au plus petit commun multiple de périodes entre le signal de l'oscillateur commandé en tension et celui de l'oscillateur de référence.

Les synthétiseurs de fréquence actuels à boucle de phase et pas fractionnaires utilisent un compteur-diviseur à au moins deux rangs entiers successifs de division N et N+1 et un accumulateur numérique modulo P, à incrément entier K inférieur à P et ajustable, cadencé par le signal de sortie du compteur-diviseur, pour commander des passages du rang de division de ce compteur-diviseur de N à N+1 et inversement. Il en résulte que le début d'un train d'ondes, qui coïncide avec un changement de l'incrément K par lequel on ajuste le rapport de division fractionnaire, peut survenir indifféremment à l'occasion d'un débordement quelconque du compteur-diviseur, en plusieurs emplacements de cette durée du plus petit commun multiple des périodes entre les deux signaux, avec des valeurs diverses de décalage de phase. Cet aléa provoque un manque de cohérence entre des trains d'ondes de même fréquence, si, entre temps, le synthétiseur de fréquence a été commuté en fréquence.

Un tel synthétiseur de fréquence est décrit dans la demande de brevet EP-A-0 557 799.

La présente invention a pour but des synthétiseurs de fréquence à boucle de phase et pas fractionnaires capables d'engendrer des signaux cohérents même après une excursion de fréquence.

Elle a pour objet un synthétiseur de fréquence à boucle de phase et pas fractionnaires comportant un oscillateur de référence, un oscillateur commandé en tension, une boucle d'asservissement de phase recevant en entrées, le signal de l'oscillateur commandé en tension et celui de l'oscillateur de référence, délivrant en sortie la commande en tension de l'oscillateur commandé en tension et comprenant un comparateur de phase connecté d'une part, directement à la sortie de l'oscillateur de référence et d'autre part, à la sortie de l'oscillateur commandé en tension par l'intermédiaire d'un compteur-diviseur à rang entier de division ajustable, ledit compteur-diviseur avec au moins deux rangs successifs entiers de division N et N+1 commutables et un circuit de commande du rang instantané de division appliqué au compteur-diviseur effectuant au moins une accumulation numérique modulo P, à incrément K entier, ajustable et inférieur à P, et changeant le dit rang instantané de division en fonction des débordements de ladite accumulation numérique, le circuit de commande du rang instantané de division appliqué au compteur-diviseur comportant au moins un compteur modulo P, à incrément unité, cadencé à la fréquence du signal de l'oscillateur de référence et utilisé en mémoire de phase pour permettre les changements, à des instants synchrones de l'oscillateur de référence, de la valeur de l'incrément K de l'accumulation numérique, consécutifs à des changements du rapport de division fractionnaire, tout en conservant, pour une fréquence donnée, un même décalage de phase par rapport à un signal pilote.

Selon un mode préféré de réalisation, le synthétiseur de fréquence à boucle de phase et pas fractionnaires a un circuit de commande du rang instantané de division de son compteur-diviseur qui comporte, outre le compteur modulo P à incrément unité, un multiplieur modulo P multipliant le compte du compteur modulo P à incrément unité par l'incrément K de l'accumulation numérique, un comparateur comparant le signal de sortie du multiplieur modulo P avec l'incrément K de l'accumulation numérique et engendrant un signal de débordement chaque fois qu'il constate que le signal de sortie du multiplieur modulo P est strictement inférieur à la valeur de l'incrément K de l'accumulation numérique, et un moyen de synchronisation synchronisant le signal de débordement du comparateur avec le signal de sortie du compteur-diviseur avant de l'appliquer au compteur-diviseur en tant que commande de changement de rang de division.

Selon une variante, le comparateur comparant le signal de sortie du multiplieur modulo P à l'incrément K de l'accumulation numérique engendre un signal de débordement chaque fois qu'il constate que le signal de sortie du multiplieur modulo P est supérieur ou égal au modulo P moins l'incrément K de l'accumulation numérique au lieu d'être strictement inférieur à la valeur de l'incrément K de l'accumulation numérique.

Selon un autre mode de réalisation, le synthétiseur de fréquence à boucle de phase et pas fractionnaires a un circuit de commande du rang instantané de division de son compteur-diviseur qui comporte, outre le compteur modulo P à incrément unité, un accumulateur modulo P, à incrément K, cadencé à la fréquence de l'oscillateur de référence, une mémoire d'incrément K qui reçoit un ordre d'écriture d'une sortie de débordement du compteur modulo P à incrément unité et qui est connectée en sortie lecture de données à une entrée d'incrément de l'accumulateur modulo P à incrément K, et un moyen de synchronisation synchronisant le signal de débordement de l'accumulateur avec le signal de sortie du compteur-diviseur avant de l'appliquer au compteur-diviseur en tant que commande de changement de rang de division.

Selon une variante adaptée aux pas fractionnaires multiples où la fréquence et l'importance des changements du rang de division du compteur-diviseur dépendent de l'occurrence des débordements de différentes accumulations numériques modulo des entiers $P_1$, $P_2$,..., $P_s$ premiers entre eux, avec divers incréments entiers variables, menées en parallèle à la fréquence de l'oscillateur de référence, le circuit de commande du rang instantané de division du compteur-diviseur est dédoublé en une multiplicité de circuits effectuant chacun, de façon implicite ou explicite, l'une desdites accumulations numériques et engendrant des signaux individuels de débordement additionnés par un circuit sommateur numérique avant d'être appliqués à la commande de changement de rang du compteur-diviseur.

D'autres caractéristiques et avantages de l'invention ressortiront de la description ci-après de plusieurs modes de réalisation donnés à titre d'exemple. Cette description sera faite en regard du dessin dans lequel :

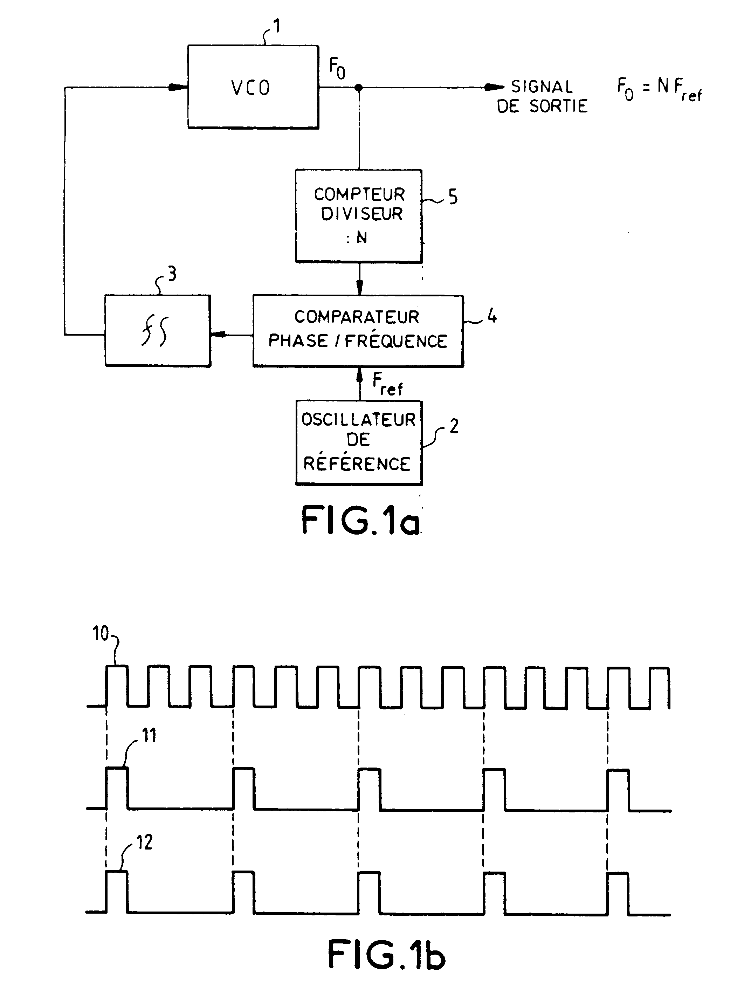

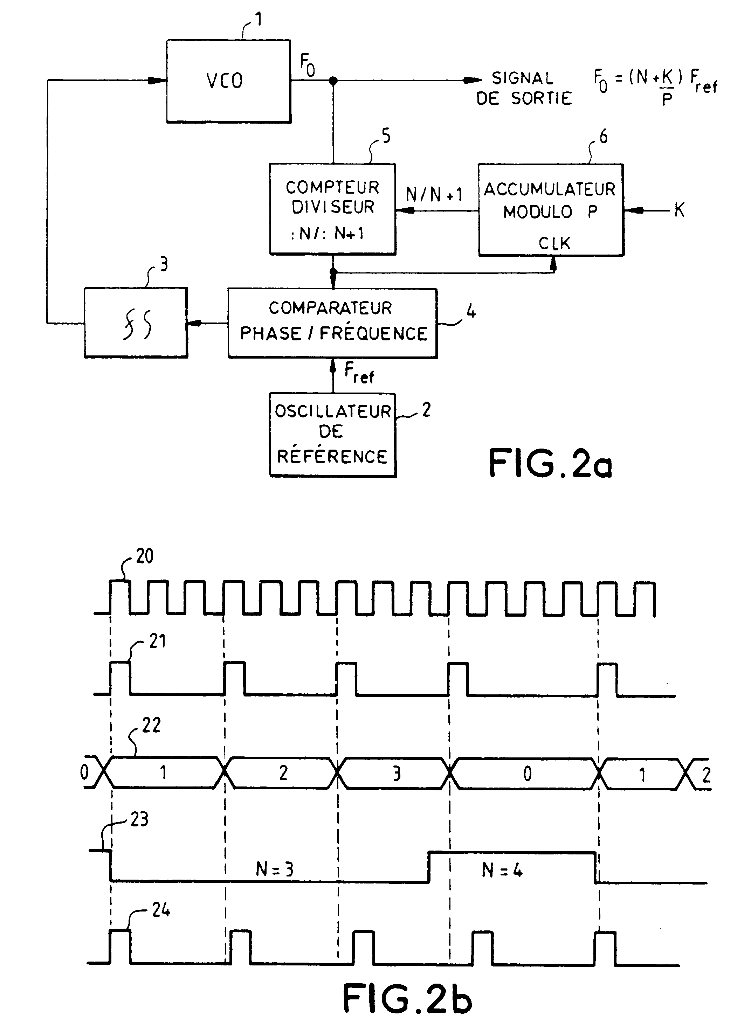

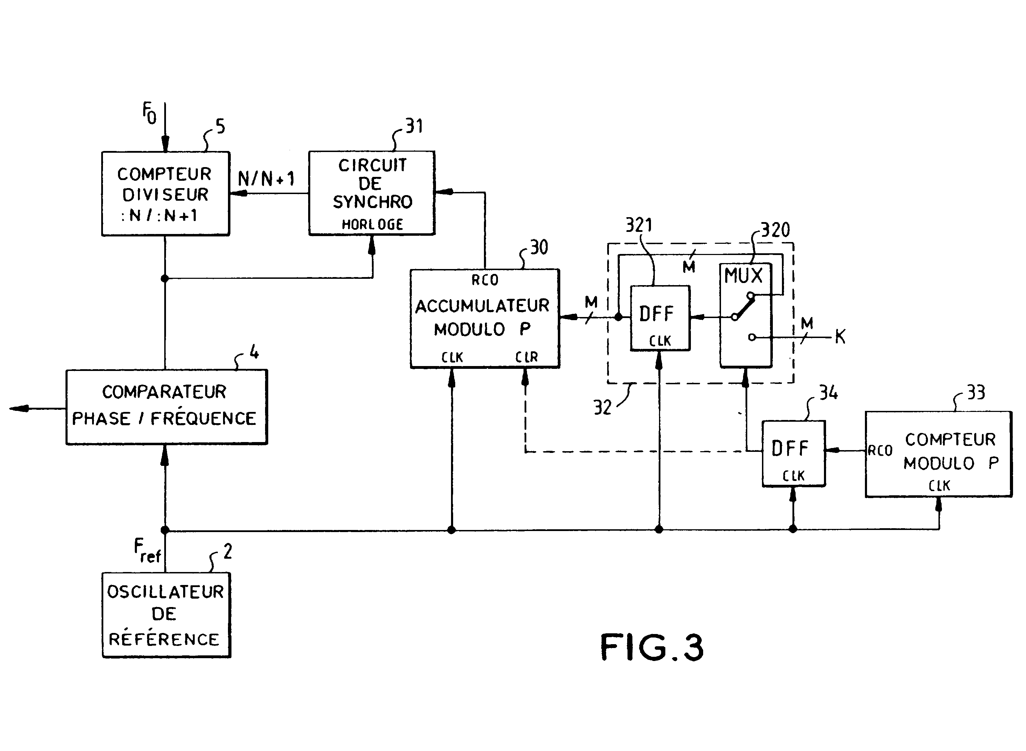

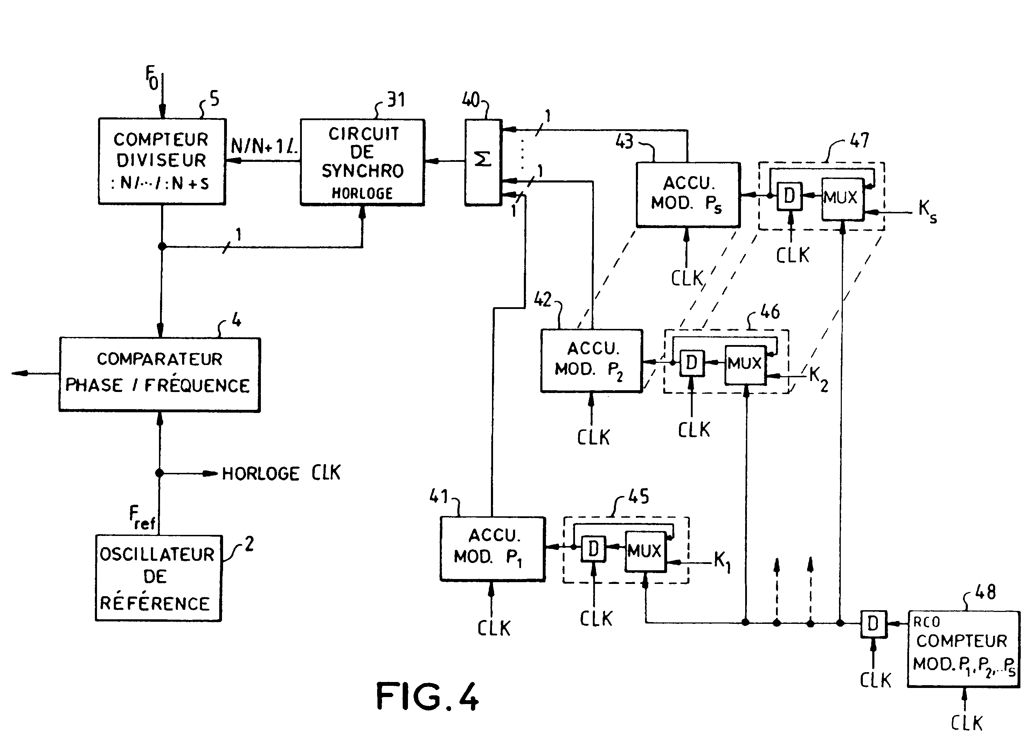

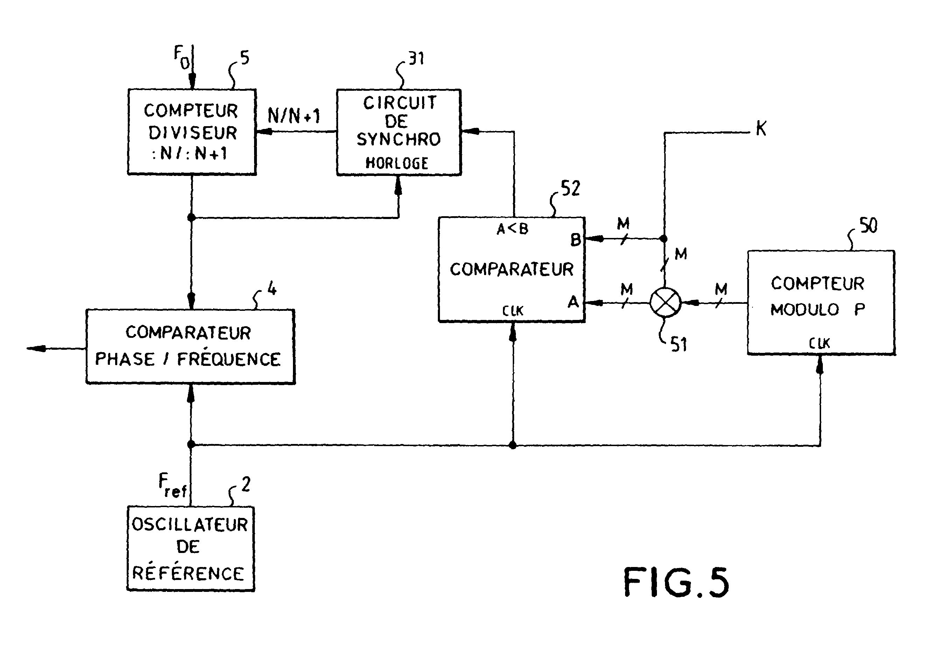

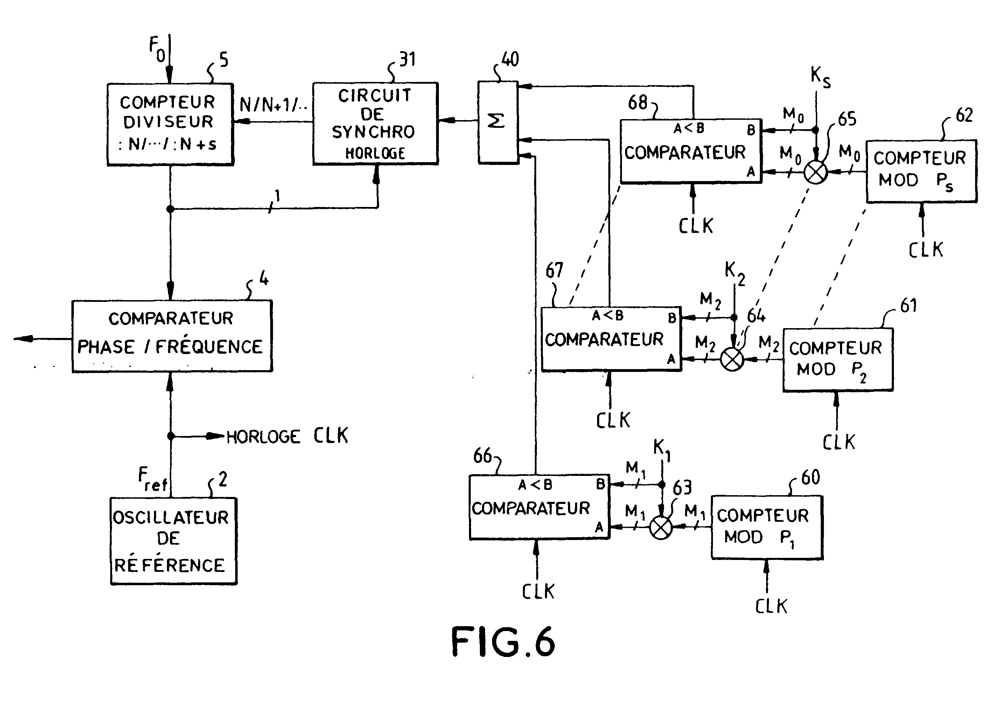

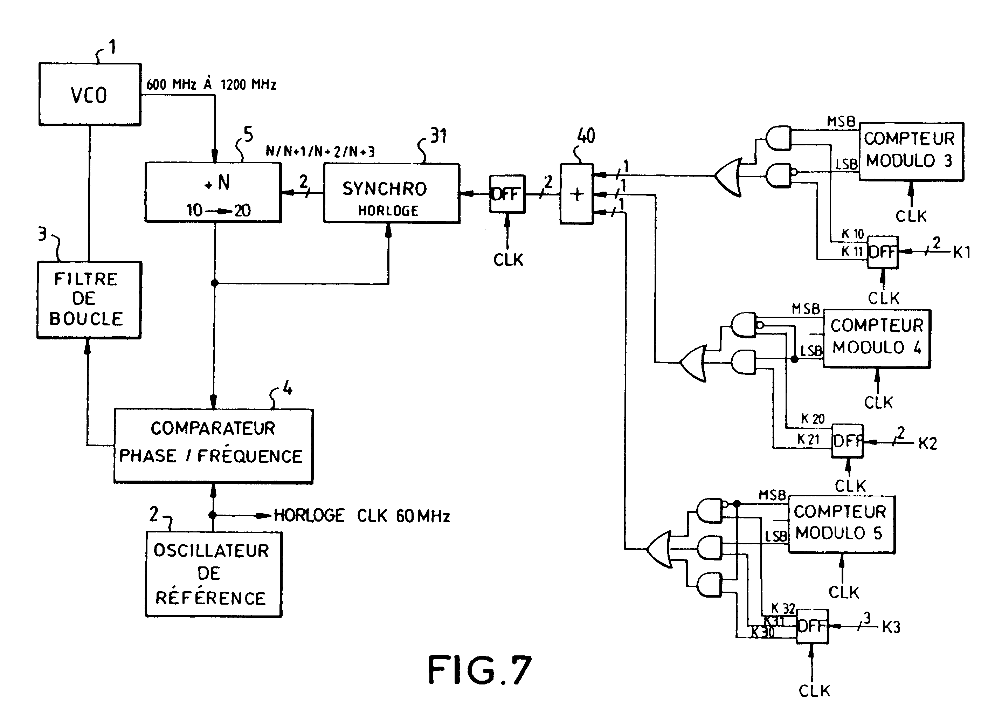

- une figure 1a montre un schéma de principe d'un synthétiseur de fréquence à boucle de phase et pas entiers de division,
- une figure 1b représente un diagramme de courbes illustrant le fonctionnement du synthétiseur représenté à la figure 1a et montrant la cohérence de phase des trains d'ondes qui en sont issus,
- une figure 2a est un schéma synoptique montrant la modification que l'on apporte habituellement à un synthétiseur de fréquence à boucle de phase et pas entiers de division pour le transformé en synthétiseur à pas fractionnaires,
- une figure 2b représente un diagramme de courbes illustrant le fonctionnement du synthétiseur à pas fractionnaires représenté à la figure 2a et montrant pourquoi les trains d'ondes qui en sont issus ne sont pas cohérents,
- une figure 3 est un schéma synoptique d'un circuit selon l'invention permettant d'obtenir des pas fractionnaires dans un synthétiseur de fréquence à boucle de phase tout en conservant une cohérence de phase pour les trains d'ondes qui en sont issus,
- une figure 4 est une extension du schéma de la figure précédente à un synthétiseur de fréquence à boucle de phase et pas fractionnaires multiples,
- une figure 5 est un schéma synoptique d'un autre circuit selon l'invention permettant également d'obtenir des pas fractionnaires dans un synthétiseur à boucle de phase tout en conservant la cohérence de phase pour les trains d'ondes qui en sont issus,
- une figure 6 est une extension du schéma de la figure précédente à un synthétiseur de fréquence à boucle de phase et pas fractionnaires multiples, et
- une figure 7 est un schéma montrant la simplicité de mise en oeuvre du schéma synoptique de la figure précédente dans un cas pratique.

Comme le montre la figure 1, un synthétiseur de fréquence à boucle de phase et pas entiers se compose d'un oscillateur commandé en tension VCO 1 asservi en phase sur un oscillateur de référence 2 au moyen d'une boucle d'asservissement de phase. La boucle d'asservissement de phase comporte un filtre de boucle 3, un comparateur phase-fréquence 4 et un compteur-diviseur 5. Le filtre de boucle 3 est connecté entre l'entrée de commande en tension de l'oscillateur commandé en tension VCO 1 et la sortie d'un comparateur phase-fréquence 4. Le comparateur phase-fréquence 4 a deux entrées : l'une connectée directement à la sortie de l'oscillateur de référence 2 et l'autre connectée à la sortie de l'oscillateur commandé en tension VCO 1 par l'intermédiaire du compteur-diviseur 5.

L'oscillateur commandé en tension VCO 1 délivre le signal de sortie à la fréquence $F_0$ du synthétiseur de fréquence. L'oscillateur de référence 2 délivre un signal de référence à fréquence $F_{ref}$. Le compteur diviseur 5 divise, dans un rapport entier N, la fréquence $F_0$ du signal de l'oscillateur commandé en tension VCO 1 avant de le soumettre au comparateur phase-fréquence 4 de sorte que la boucle de phase assure l'égalité :

$$F_0 = N \times F_{ref}$$

Le plus petit commun multiple de périodes entre le signal de l'oscillateur commandé VCO 1 et celui de l'oscillateur de référence 2 est égal à une période de l'oscillateur de référence.

La figure 1b illustre, de manière simplifiée ne tenant pas compte des déphasages constants introduits par le comparateur phase-fréquence 4 et le compteur-diviseur 5, les relations temporelles entre les différents signaux apparaissant aux bornes des circuits de la figure 1a.

La courbe 10 représente le signal de sortie à la fréquence $F_0$ de l'oscillateur commandé en tension VCO 1, la courbe 11 le signal de sortie du compteur-diviseur par N 5, N étant pris égal à trois, et la courbe 12 le signal à la fréquence $F_{ref}$ de l'oscillateur de référence 2.

Le débordement du compteur-diviseur 5, qui est repéré sur la figure 1b par des pointillés, se produit toujours au même instant d'une période du signal de l'oscillateur de référence 2. Comme les débuts des trains d'ondes issus du synthétiseur coïncident avec un débordement du compteur-diviseur 5 puisque c'est à cette seule occasion que le rang entier du compteur-diviseur peut être changé, tous les trains d'ondes issus du synthétiseur à une fréquence donnée ont la même phase à l'origine par rapport au signal de l'oscillateur de référence 2, même si le synthétiseur a effectué entre eux des excursions de fréquence. Ils sont donc naturellement cohérents.

Un synthétiseur de fréquence à boucle de phase et pas entiers de division engendre naturellement des trains d'ondes cohérents. Il a cependant l'inconvénient d'avoir un pas minimum de variation de fréquence égal à $F_{ref}$, ce qui est souvent trop important.

Pour diminuer le pas minimum de variation de fréquence d'un synthétiseur de fréquence à boucle de phase, il existe une technique connue appelée synthèse fractionnaire qui permet d'obtenir un pas de synthèse égal à une fraction de la fréquence de l'oscillateur de référence. Son intérêt est d'améliorer la résolution en fréquence d'un synthétiseur à boucle de phase sans en dégrader le bruit de phase.

Selon cette technique, la division fractionnaire est obtenue en changeant dynamiquement la valeur du rang entier de division du compteur-diviseur de la boucle de phase entre deux valeurs successives N et N + 1. Ainsi, pour obtenir un rapport de division fractionnaire égal à N+K/P (K et P entiers et K<P), le compteur-diviseur de la boucle de phase va diviser par un rapport N pendant P-K cycles de l'oscillateur de référence et par un rapport N+1 pendant K cycles de l'oscillateur de référence.

La méthode habituelle pour obtenir ce changement dynamique du rang de division du compteur-diviseur de la boucle de phase consiste à utiliser un accumulateur numérique modulo P à incrément K fonctionnant à la fréquence de l'oscillateur de référence pour commander par ses débordements une entrée de commande de basculement du rang de division entre les valeurs N et N + 1. C'est ce qui est représenté à la figure 2a où l'on voit qu'un accumulateur numérique modulo P à incrément K 6 a été ajouté avec son entrée d'horloge connectée à la sortie du compteur-diviseur par N 5 et sa sortie de débordement connectée à une entrée de commande de basculement du rang de division du compteur-diviseur 5 de la boucle de phase entre les valeurs N et N+1.

Le compteur-diviseur 5 divise la fréquence $F_0$ du signal de l'oscillateur commandé en tension VCO 1 dans un rapport fractionnaire N+K/P avant de le soumettre au comparateur de phase 4 de sorte que la boucle de phase assure l'égalité :

$$F_0 = (N + K / P)F_{ref}$$

ce qui s'écrit encore :

$$PT_{ref} = (NP + K)T_0$$

avec :

$$T_{ref} = \frac{1}{F_{ref}} \ et \ T_0 = \frac{1}{F_0}$$

Le plus petit commun multiple de périodes entre le signal de l'oscillateur commandé en tension VCO 1 et le signal de l'oscillateur de référence n'est plus égal à une période de l'oscillateur de référence 2 mais à P périodes ou à un sous-multiple de P périodes si le rapport K/P n'est pas irréductible.

La figure 2b illustre, toujours de manière simplifiée ne tenant pas compte des déphasages constants introduits par les différents circuits : comparateur phase-fréquence, compteur-diviseur et accumulateur numérique, les relations temporelles entre les différents signaux apparaissant aux bornes des circuits de la figure 2a.

La courbe 20 représente le signal de sortie à la fréquence $F_0$ de l'oscillateur commandé en tension VCO 1, la courbe 21 le signal de sortie du compteur-diviseur par N 5, N étant pris égal à trois, la courbe 22 le contenu de l'accumulateur numérique 6 en supposant que P est égal à quatre et l'incrément K à un, la courbe 23 la commande de débordement et la courbe 24 le signal à la fréquence $F_{ref}$ de l'oscillateur de référence 2.

Avec cet exemple, où l'on a choisi N=3, K=1 et P=4, il vient :

$$F_0 = \left( N + \frac{K}{P} \right) F_{ref} = \frac{13}{4} F_{ref} = 3{,}25 \, F_{ref}$$

Le contenu de l'accumulateur numérique 6 change à chaque impulsion en sortie du compteur-diviseur 5. Soit $C_n$ le contenu de l'accumulateur numérique au cours d'une période du signal de l'oscillateur de référence 2, son contenu $C_{n+1}$ au cours de la période suivante sera égal à :

$$C_{n+1} = C_n + K = C_n + 1$$

Le débordement de l'accumulateur numérique 6 a alors lieu une fois toutes les quatre périodes du signal de l'oscillateur de référence 2 et provoque une division par quatre au lieu d'une division par trois du signal de sortie de l'oscillateur commandé en tension. On obtient ainsi treize périodes de fréquence $F_0$ en sortie de l'oscillateur commandé en tension VCO 1 pour quatre périodes de fréquence $F_0$ de l'oscillateur de référence 2, ce qui donne le rapport fractionnaire de 3,25.

Dans cet exemple, le plus petit commun multiple de périodes entre le signal de fréquence $F_0$ de l'oscillateur commandé en tension et le signal de fréquence $F_{ref}$ de l'oscillateur de référence est de treize périodes du signal de l'oscillateur commandé pour quatre périodes de l'oscillateur de référence. Il apparaît toujours un débordement du compteur-diviseur 5 sur chaque période de l'oscillateur de référence 2 mais ce débordement se produit avec un retard variable qui dépend de la position de la période considérée de l'oscillateur de référence 2 dans une séquence correspondant au plus petit commun multiple de périodes évoqué ci-dessus. Ici, comme le plus petit commun multiple de périodes dure quatre périodes de l'oscillateur de référence 2, un débordement du compteur-diviseur 5 peut se produire pour quatre valeurs distinctes de déphasage au cours d'une période de l'oscillateur de référence 2. En supposant que le synthétiseur engendre un premier train d'ondes à une fréquence $F_1$ puis un autre train d'ondes à une fréquence différente $F_2$ impliquant un changement de l'incrément de l'accumulateur numérique, et enfin un deuxième train d'ondes à la fréquence $F_1$, il n'est pas sûr que le deuxième train d'ondes à la fréquence $F_1$ ait la même référence de phase que le premier. En effet, le changement de fréquence du synthétiseur, lorsqu'il correspond à un changement de l'incrément de l'accumulateur numérique, intervient lors d'un débordement quelconque du compteur-diviseur 5, c'est-à-dire avec un décalage de phase pouvant prendre indifféremment quatre valeurs distinctes. Les deux trains d'ondes à la fréquence $F_1$ n'ont donc pas nécessairement le même décalage de phase par rapport au signal de l'oscillateur de référence, ce qui détruit la cohérence.

Ce manque de cohérence de phase des synthétiseurs à boucle de phase et pas fractionnaires de l'art antérieur, dû à la dépendance de l'état présent de leur accumulateur numérique, en fonction de l'historique des différentes valeurs de consignes d'incrémentation appliquées au préalable, interdit leur utilisation dans certaines applications telles que par exemple celles des radars Doppler alors qu'il serait très intéressant de les mettre en oeuvre dans ces applications en raison de leur pureté spectrale.

On se propose de rendre cohérents les synthétiseurs de fréquence à boucle de phase et pas fractionnaires en leur adjoignant une mémoire de phase à base d'un compteur modulo P à incrément unité cadencé à la fréquence de l'oscillateur de référence. Cette mémoire de phase sert à se repérer au sein d'une séquence de P périodes consécutives de l'oscillateur de référence, donc par rapport au plus petit commun multiple de périodes entre le signal de l'oscillateur de référence et le signal de sortie du synthétiseur. Elle est utilisée pour faire en sorte qu'un changement d'incrément de l'accumulation numérique se produise toujours avec le même décalage de phase par rapport à ce plus petit commun multiple de périodes. On a en effet vu que ce plus petit commun multiple de périodes était égal ou sous-multiple de P périodes de l'oscillateur de référence.

Pour conserver la même référence de phase par rapport à ce plus petit commun multiple de périodes entre les signaux de l'oscillateur commandé en tension et de l'oscillateur de référence, on peut utiliser la mémoire de phase à compteur modulo P et incrément unité fonctionnant à la fréquence de l'oscillateur de référence pour n'autoriser les changements de l'incrément de l'accumulation numérique que toutes les P périodes de l'oscillateur de référence ce qui conduit à un premier mode de réalisation. Cependant, n'autoriser les changements de l'incrément de l'accumulation numérique que toutes les P périodes de l'oscillateur de référence introduit, dans la génération des trains d'ondes, des délais qui peuvent être gênants dans certaines applications. Pour les éviter, on peut utiliser la mémoire de phase à compteur modulo P et incrément unité fonctionnant à la cadence de l'oscillateur de référence pour repérer les instants de débordement d'une l'accumulation numérique initiée au démarrage du synthétiseur ce qui conduit à un deuxième mode de réalisation.

La figure 3 illustre le premier mode de réalisation. Dans un but de simplification, l'oscillateur commandé en tension 1 et le filtre de boucle 3 ont été omis mais on retrouve l'oscillateur de référence 2 ainsi que le compteur-diviseur 5 et le comparateur phase-fréquence 4 de la boucle de phase. Le compteur-diviseur 5 a deux rangs entiers successifs possibles de division N et N+1 ainsi qu'une entrée de commande de basculement entre ces deux rangs. Cette commande de basculement de rang de division du compteur-diviseur 5 est pilotée, comme précédemment, par une sortie de débordement d'un accumulateur numérique 30 modulo P à incrément entier K variable et inférieur à P, fonctionnant à la fréquence de l'oscillateur de référence 2 mais cet accumulateur numérique 30 est connecté différemment. Il n'est plus cadencé par le signal de sortie du compteur-diviseur 5 qui n'est à la fréquence de l'oscillateur de référence 2 que lorsque la boucle de phase parvient à son équilibre mais par le signal de l'oscillateur de référence 2 lui-même. pour tenir compte de cette modification, sa sortie de débordement n'est plus reliée à la commande de basculement de rang du compteur-diviseur 5 directement mais par l'intermédiaire d'un circuit de synchronisation 31. Celui-ci est cadencé par le signal de sortie du compteur-diviseur 5 de manière à échantillonner l'état de la sortie de débordement de l'accumulateur numérique 30 au rythme des débordements du compteur-diviseur 5.

L'entrée d'incrément K de l'accumulateur numérique 30 modulo P 30 est connectée en sortie d'une mémoire numérique d'incrément 32 dont l'inscription est commandée par le signal de débordement d'une mémoire de phase à compteur modulo p à incrément unité 33 cadencé par le signal de l'oscillateur de référence 2. La mémoire numérique d'incrément 32 est constituée par exemple, d'un multiplexeur 320 à deux entrées de données, une sortie de données et une entrée d'adressage, et d'un banc de bascules logiques de type D 321. L'une des entrées de données du multiplexeur 320 est rebouclée à sa sortie par l'intermédiaire du banc de bascules logiques de type D 321 cadencées par le signal de l'oscillateur de référence 2. L'autre entrée de données du multiplexeur 320 reçoit la consigne d'incrément K. L'entrée d'adressage du multiplexeur 320 est connectée à une sortie de débordement du compteur modulo P à incrément unité 33 par l'intermédiaire d'une bascule logique de type D 34 cadencée par l'oscillateur de référence 2. L'adressage du multiplexeur 320 est tel qu'en l'absence de débordement du compteur modulo P à incrément unité 33, sa sortie de données soit rebouclée sur elle-même par l'intermédiaire du banc de bascules logiques de type D 321. On réalise ainsi une mémoire d'incrément mise à jour uniquement à chaque débordement du compteur modulo P à incrément unité 33 qui sert de mémoire de phase et n'autorise un changement d'incrément K pour l'accumulateur numérique 30 modulo P que toutes les P périodes de l'oscillateur de référence 2. Cela garantit, comme on l'a vu précédemment, la cohérence de phase entre tous les trains d'ondes engendrés à une même fréquence par le synthétiseur de fréquence, même si le synthétiseur de fréquence a effectué des excursions de fréquence entre les générations de ces trains d'ondes.

En variante, la sortie de la bascule logique de type D 34 peut être aussi connectée à une entrée de remise à zéro de l'accumulateur numérique 30 ce qui synchronise les passages par zéro de l'accumulateur numérique 30 sur ceux du compteur modulo P à incrément unité 33 de la mémoire de phase. Cette possibilité est rappelée sur la figure 3 par une liaison en pointillés entre la sortie de la bascule logique de type D 34 et une entrée de remise à zéro de l'accumulateur numérique modulo P 30.

La figure 4 montre une extension du schéma de la figure 3 à un synthétiseur de fréquence à boucle de phase et pas fractionnaires multiples. Les synthétiseurs à boucle de phase et pas fractionnaires multiples se différencient des synthétiseurs à boucle de phase et pas fractionnaires simples par le fait qu'ils utilisent dans leur boucle de phase un compteur-diviseur à plus de deux rangs entiers successifs possibles de division : N, N+1, N+2,..., N+s, dont la commande de basculement de rang de division est contrôlée par la sortie d'un additionneur numérique 40 recevant les commandes de débordements de s accumulateurs numériques distincts 41, 42,..., 43 modulo des nombres entiers distincts $P_1$, $P_2$,...,$P_s$ premiers entre eux, fonctionnant tous à la fréquence de l'oscillateur de référence 2 avec des incréments entiers variables $K_0$, $K_1$,..., $K_s$. Chaque accumulateur numérique 41, 42,..., 43 reçoit son incrément $K_0$, $K_1$,..., $K_s$ d'une mémoire individuelle d'incrément 45, 46,..., 47 mise à jour uniquement à chaque débordement d'un compteur 48 modulo le produit

$$\prod_{i=1}^{s} P_i \, ,$$

à incrément unité qui fonctionne à la fréquence de l'oscillateur de référence 2 et sert de mémoire commune de phase.

Avec un tel montage, on voit que le changement de fréquence, par changement d'incrément, n'est possible que toutes les

$$\prod_{i=1}^{s} P_i$$

périodes de l'oscillateur de référence. Cela peut conduire à des délais de fonctionnement gênants dans des applications où il est nécessaire de changer de fréquence très rapidement tout en sauvegardant la cohérence. Pour réduire ces délais de commutation, on peut utiliser la mémoire de phase pour maintenir la cohérence en se repérant uniquement sur les instants de débordement d'une l'accumulation numérique initiée systématiquement au démarrage du synthétiseur.

Soit une accumulation numérique C modulo P, avec un incrément K entier quelconque inférieur à P, effectuée au rythme de l'oscillateur de référence et initiée au démarrage du synthétiseur de fréquence à la période 0 de l'oscillateur de référence :

$$C_0 = 0$$

A la n ème période de l'oscillateur de référence, elle aura pour valeur :

$$C_n = (n.K) \bmod P \tag{1}$$

Pour l'exprimer en fonction du contenu de la mémoire de phase qui est un compteur modulo P à incrément unité fonctionnant au rythme de l'oscillateur de référence, il faut faire apparaître dans l'expression précédente le terme :
$n \bmod P$

Pour ce faire, on pose :

$$X = n - (n \bmod P) \tag{2}$$

En remplaçant dans la relation (1) n par sa valeur prise dans la relation (2), il vient :

$$C_n = (X.K) \bmod P + [(n \bmod P).K] \bmod P$$

Comme P divise X on peut écrire :

$$(X.K) \bmod P = 0$$

D'où :

$$C_n = [(n \bmod P).K] \bmod P$$

Cette dernière expression montre que le contenu d'une accumulation numérique d'incrément K, effectuée au rythme de l'oscillateur de référence et initiée au démarrage du synthétiseur est égal au produit modulo P de l'incrément K par le contenu de la mémoire de phase qui est elle-même un compteur modulo P à incrément unité fonctionnant au rythme de l'oscillateur de référence. Il est donc possible de connaître à tout instant le contenu de cette accumulation numérique en multipliant modulo P l'incrément K par le contenu de la mémoire de phase.

Connaissant le contenu de cette accumulation numérique initiée au démarrage du synthétiseur, il est possible d'en déduire les périodes de l'oscillateur de référence au cours desquelles il déborde. En effet, si ce contenu est strictement inférieur à l'incrément K, cela signifie qu'il a débordé au cours de la période précédente de l'oscillateur de référence. Si ce contenu est supérieur ou égal à l'incrément K, cela signifie qu'il n'a pas débordé au cours de la période précédente de l'oscillateur de référence. On constate donc que la valeur vraie, respectivement fausse, de l'expression :

$$[(n \bmod P).K] \, K \bmod P < K$$

donne, à un décalage temporel près, la valeur 1, respectivement 0, du signal de débordement d'un accumulateur numérique qui aurait été initié au démarrage du synthétiseur. Ce décalage temporel n'a pas d'importance pour la cohérence car il est constant.

En variante, on peut également comparer le contenu de l'accumulation numérique initiée au démarrage du synthétiseur avec la valeur P-K. En effet, si le contenu de l'accumulation numérique est supérieur ou égal à la valeur P-K, il y aura un débordement à la prochaine période de l'oscillateur de référence, si non il n'y aura pas de débordement.

La figure 5 montre un schéma de synthétiseur de fréquence cohérent à boucle de phase et pas fractionnaires basé sur un calcul implicite des débordements d'une accumulation numérique modulo P à incrément entier K faite au rythme de l'oscillateur de référence et initiée au démarrage du synthétiseur. Comme dans la figure 3, l'oscillateur commandé en tension 1 et le filtre de boucle 3 ont été omis mais on retrouve l'oscillateur de référence 2 ainsi que le compteur-diviseur 5 et le comparateur phase-fréquence 4 de la boucle de phase. Le compteur-diviseur 5 a toujours deux rangs entiers successifs possibles de division N et N+1 et une entrée de commande de basculement entre ces deux rangs connectée en sortie d'un circuit de synchronisation 31 qui est cadencé par le signal de sortie du compteur-diviseur 5 et qui échantillonne l'état d'un signal de commande de basculement entre les rangs successifs de division N et N+1 au rythme des débordements du compteur-diviseur 5.

Le signal de basculement entre les rangs successifs de division N et N+1 appliqué en entrée du circuit de synchronisation 31 provient d'un circuit de commande du rang instantané de division qui calcule, de manière implicite, une accumulation numérique modulo P, avec un incrément K initiée au démarrage du synthétiseur et qui repère les périodes de l'oscillateur de référence 2 au cours desquelles cette accumulation numérique déborde. Ce circuit de commande se compose d'un compteur 50 modulo P à incrément unité, cadencé par l'oscillateur de référence 2, d'un multiplieur numérique modulo P 51 à deux entrées de données et d'un comparateur numérique 52 à deux entrées parallèles de données A et B, une entrée d'horloge et une sortie de comparaison A<B.

Le multiplieur 51 reçoit sur l'une de ses entrées le compte du compteur modulo P 50 et sur l'autre la valeur en numérique de l'incrément K de l'accumulation. Il est connecté en sortie à l'entrée de données A du comparateur numérique 52. Le comparateur numérique 52 reçoit sur son autre entrée de données B la valeur en numérique de l'incrément K de l'accumulation tandis que son entrée d'horloge est connectée à la sortie de l'oscillateur de référence 2 et que sa sortie de comparaison A<B constitue celle du circuit de commande.

Le compteur 50 modulo P à incrément unité cadencé par l'oscillateur de référence 2 constitue une mémoire de phase. Il fournit un compte n mod P des périodes de l'oscillateur de référence depuis la mise en route du synthétiseur. Le multiplieur modulo P 51 délivre le produit modulo P de ce compte par la valeur de l'incrément K de l'accumulation :
$[(n \bmod P).K] \bmod P$
c'est-à-dire, comme on vient de le voir, la valeur de l'accumulation numérique modulo P et incrément K effectuée au rythme de l'oscillateur de référence 2 depuis la mise en route du synthétiseur et ceci, quel que soit l'historique des changements de valeur de l'incrément K. Le comparateur 52 détecte par mise en oeuvre de la relation :

$$[(n \bmod P).K] \bmod P < K$$

les périodes du signal de l'oscillateur de référence 2 où cette accumulation numérique déborde. Il effectue cette détection avec un retard constant d'une période de l'oscillateur de référence qui est sans importance puisque constant. Puis ces détections sont utilisées après resynchronisation sur les débordements du compteur-diviseur 5 pour commuter momentanément le rang de division du compteur-diviseur 5 à la valeur N+1 et obtenir le pas fractionnaire désiré. Comme l'accumulation numérique considérée part toujours de la mise en route du synthétiseur, tous les trains d'ondes de même fréquence engendrés par le synthétiseur au cours de son fonctionnement sont cohérents en phase, cela quel que soit l'historique des changements de valeur de l'incrément K.

La figure 6 montre une extension du schéma de la figure 5 à un synthétiseur de fréquence à boucle de phase et pas fractionnaires multiples. Le compteur-diviseur 5 de la boucle de phase possède s rangs entiers consécutifs de division N, N+1,..., N+s et une commande de sélection de l'un de ces rangs de division connectée à la sortie d'un circuit de commande de rang instantané de division par l'intermédiaire d'un circuit de synchronisation 31 assurant la prise en compte d'un rang de division sélectionné en synchronisme avec les débordements du compteur-diviseur 5.

Le circuit de commande de rang instantané de division comporte un banc de s circuits partiels de calcul implicite d'accumulation numérique et de repérage des débordements de l'accumulation calculée, et un additionneur numérique 40 qui additionne en sortie les s signaux de détection de débordement délivrés par le banc des s circuits partiels. Pour fournir ces s signaux de débordement, les s circuits partiels du banc effectuent en parallèle, au rythme de l'oscillateur de référence 2, s accumulations numériques modulo s nombres entiers premiers entre eux $P_1$, $P_2$,..., $P_s$, avec des incréments entiers variables $K_1$, $K_2$,.., $K_s$ et repèrent les périodes de l'oscillateur de référence 2 au cours desquelles elles débordent. Chacun de ces circuits partiels comporte, comme le circuit de commande de rang instantané de division de la figure 5, un compteur 60, respectivement 61,..., 62 à incrément unité cadencé par le signal de l'oscillateur de référence 2, un multiplieur numérique 63, respectivement 64,..., 65 effectuant le produit de l'incrément par le compte du compteur 60, respectivement 61,.., ou 62 et un comparateur numérique 66, respectivement 67,..., 68 détectant les périodes de l'oscillateur de référence 2 où le produit délivré par le multiplieur est strictement inférieur à l'incrément. Chaque circuit partiel de calcul implicite et de repérage diffère des autres par la valeur du modulo avec lequel il effectue le compte de périodes de l'oscillateur de référence et le produit de ce compte avec la valeur de l'incrément. Ainsi, le i éme possède un compteur et un multiplieur modulo $P_i$, les modulo $P_1$, $P_2$,.., $P_i$,.., $P_s$ étant tous différents et premiers entre eux.

La complexité du circuit de la figure 6 n'est qu'apparente car, dans la plupart des cas, le comparateur et le multiplieur de chaque circuit partiel de commande de rang instantané de division peuvent être réalisés à l'aide d'une combinaison relativement simple de portes logiques.

Soit, par exemple, un synthétiseur de fréquence cohérent couvrant la bande 600 MHz à 1200 MHz à partir d'un oscillateur de référence à 60 MHz et d'une structure à pas fractionnaires multiples avec les modulo 3, 4 et 5 lui donnant une résolution de :

$$\frac{F_{ref}}{P_1 P_2 P_3} = 1 \; MHz$$

Selon l'architecture de la figure 6, il renferme trois circuits partiels de calcul implicite d'accumulation numérique et de repérage des débordements de l'accumulation numérique calculée qui calculent en parallèle trois accumulations numériques modulo 3, 4 et 5, avec des incréments divers, au rythme de l'oscillateur de référence et repèrent leurs débordements, et dont les signaux binaires de sortie sont additionnés pour servir, après resynchronisation, de commande de sélection du rang instantané de division du compteur-diviseur de la boucle de phase. Comme on l'a vu précédemment, ces trois circuits partiels de calcul et de repérage doivent délivrer en sortie un signal binaire correspondant à la validité ou la non validité de l'inégalité :

$$[(n \bmod P).K] \bmod P < K$$

établie pour les modulo 3, 4 et 5, et pour les valeurs d'incrément K choisies. L'étude des états logiques de leurs signaux de sortie se ramène donc à celles des tableaux des états logiques vrai ou faux pris par cette inégalité pour chacun des modulo 3,4 et 5, en fonction d'une part, des valeurs balayées par le compteur modulo de la mémoire de phase, et d'autre part, des valeurs possibles pour l'incrément. Or ces tableaux montrent que les états logiques vrai ou faux pris par l'inégalité répondent à trois équations logiques dépendant du modulo :

- une première équation logique pour le modulo 3 :

$$MSB(n \bmod 3).LSB(K) + \overline{LSB(n \bmod 3)}.MSB(K)$$

- une deuxième équation logique pour le modulo 4:

$$MSB(n \bmod 4). \overline{LSB(n \bmod 4)}.LSB(K) + LSB(n \bmod 4).MSB(K)$$

- une troisième équation logique pour le modulo 5 :

$$\overline{MSB(n \bmod 5)}.MSB(K) + LSB(n \bmod 5).ISB(K) + MSB(n \bmod 5).MSB(K)$$

MSB(x) étant le bit de plus fort poids de $\times$, ISB(x) le bit de poids moyen de x supposé codé sur trois bits, et LSB(x) le bit de plus faible poids de x.

Ces trois équations logiques montrent que, dans ce cas, les multiplieurs et comparateurs des circuits partiels de calcul et de repérage du schéma de la figure 6 peuvent être obtenus à l'aide de quelques portes logiques.

La figure 7 montre la relative simplicité du schéma qui en résulte.

**Revendications**

1. Synthétiseur de fréquence cohérent à boucle de phase et pas fractionnaires comportant un oscillateur de référence (2), un oscillateur commandé en tension (1), une boucle d'asservissement de phase recevant en entrées, le signal de l'oscillateur commandé en tension (1) et celui de l'oscillateur de référence (2), délivrant en sortie la commande en tension de l'oscillateur commandé en tension (1) et comprenant un comparateur de phase (4) connecté d'une part directement à la sortie de l'oscillateur de référence (2) et d'autre part à la sortie de l'oscillateur commandé en tension (1) par l'intermédiaire d'un compteur-diviseur (5) à rang entier de division ajustable, ledit compteur-diviseur (5) avec au moins deux rangs successifs entiers de division N et N+1 commutables et un circuit de commande du rang instantané de division appliqué au compteur-diviseur (5) effectuant au moins une accumulation numérique modulo P, à incrément K entier, ajustable et inférieur à P, et changeant le dit rang instantané de division en fonction des débordements de ladite accumulation numérique, ledit synthétiseur étant caractérisé en ce que le circuit de commande du rang instantané de division appliqué au compteur-diviseur (5) comporte au moins un compteur modulo P, à incrément unité (33, 50), cadencé à la fréquence du signal de l'oscillateur de référence (2) et utilisé en mémoire de phase pour imposer les changements de valeur de l'incrément K de l'accumulation numérique, consécutifs à des changements du rapport de division fractionnaire, en des instants ne modifiant pas la référence de phase de l'origine de ladite accumulation numérique par rapport au signal de l'oscillateur de référence (2).

**2.** Synthétiseur de fréquence selon la revendication 1, caractérisé en ce que ledit circuit de commande du rang instantané de division du compteur-diviseur (5) comporte, outre le compteur modulo P à incrément unité (50), un multiplieur modulo P (51) multipliant le compte du compteur modulo P à incrément unité (50) par l'incrément K de l'accumulation numérique, un comparateur (52) comparant le signal de sortie du multiplieur modulo P (51) avec l'incrément K de l'accumulation numérique et engendrant un signal de débordement chaque fois qu'il constate que le signal de sortie du multiplieur modulo P (51) est strictement inférieur à la valeur de l'incrément K de l'accumulation numérique, et un moyen de synchronisation (31) synchronisant le signal de débordement du comparateur (52) avec le signal de sortie du compteur-diviseur (5) avant de l'appliquer au compteur-diviseur (5) en tant que commande de changement de rang de division.

**3.** Synthétiseur de fréquence selon la revendication 1, caractérisé en ce que ledit circuit de commande du rang instantané de division du compteur-diviseur (5) comporte, outre le compteur modulo P à incrément unité (50), un multiplieur modulo P (51) multipliant le compte du compteur modulo P à incrément unité (50) par l'incrément K de l'accumulation numérique, un comparateur (52) comparant le signal de sortie du multiplieur modulo P (51) avec l'incrément K de l'accumulation numérique et engendrant un signal de débordement chaque fois qu'il constate que le signal de sortie du multiplieur modulo P (51) est supérieur ou égal à la différence entre les valeurs du modulo P et de l'incrément K de l'accumulation numérique, et un moyen de synchronisation (31) synchronisant le signal de débordement du comparateur (52) avec le signal de sortie du compteur-diviseur (5) avant de l'appliquer au compteur-diviseur (5) en tant que commande de changement de rang de division.

**4.** Synthétiseur selon la revendication 2 ou la revendication 3, à pas fractionnaires multiples avec, dans sa boucle de phase, un compteur-diviseur (5) à s rangs entiers successifs de division N, N+1,,.., N+s et, pour la commande du rang instantané de division dudit compteur-diviseur (5), un circuit de commande de rang instantané de division effectuant, en parallèle, au rythme de l'oscillateur de référence (2), s accumulations numériques, selon s modulo premiers entre eux $P_1,..,P_s$ et avec des incréments entiers variables inférieurs au modulo, et comportant pour ce faire s circuits partiels de calcul implicite d'accumulation numérique et de repérage des débordements de l'accumulation numérique calculée, et un additionneur numérique (40) combinant en sortie les s signaux logiques de repérage de débordement délivrés par les circuits partiels, caractérisé en ce que chacun desdits circuits partiels de calcul implicite d'accumulation numérique et de repérage des débordements de l'accumulation numérique calculée comporte un compteur individuel (60, 61 ou 62) opérant au rythme de l'oscillateur de référence (2) selon un modulo particulier $P_i$, un multiplieur individuel (63, 64 ou 65) selon le modulo particulier $P_i$ et un comparateur numérique individuel (66, 67 ou 68) comparant le signal de sortie du multiplieur modulo $P_i$ avec l'incrément d'accumulation et délivrant un signal de débordement en fonction du résultat de la comparaison.

**5.** Synthétiseur selon la revendication 4, à pas fractionnaires multiples avec, dans sa boucle de phase, un compteur-diviseur (5) à trois rangs entiers successifs de division N, N+1 et N+2 et, pour la commande du rang instantané de division dudit compteur-diviseur (5), un circuit de commande de rang instantané de division effectuant, en parallèle, au rythme de l'oscillateur de référence (2), trois accumulations numériques, selon trois modulo 3, 4 et 5 premiers entre eux et avec des incréments entiers variables inférieurs au modulo, caractérisé en ce que le multiplieur et le comparateur de chacun desdits circuits partiels de calcul implicite d'accumulation numérique et de repérage des débordement de l'accumulation numérique calculée sont obtenus à l'aide d'une combinaison de portes logiques répondant, pour le modulo 3, à l'équation logique :

$$MSB(n \bmod 3).LSB(K) + \overline{LSB(n \bmod 3)}. MSB(K)$$

pour le modulo 4, à l'équation logique :

$$MSB(n \bmod 4).\overline{LSB(n \bmod 4)}.LSB(K)+LSB(n \bmod 4).MSB(K)$$

et pour le modulo 5, à l'équation logique :

$$\overline{MSB(n \bmod 5)}.MSB(K)+LSB(n \bmod 5).ISB(K)+MSB(n \bmod 5).MSB(K)$$

n étant un compte des périodes de l'oscillateur de référence (2) depuis un instant arbitraire, K un incrément d'accumulation numérique, MSB(x) le bit de plus fort poids de x, ISB(x) le bit de poids moyen de x supposé codé sur trois bits et LSB(x) le bit de plus faible poids de x.

6. Synthétiseur selon la revendication 1, caractérisé en ce que ledit circuit de commande du rang instantané de division du compteur-diviseur (5) comporte, outre le compteur (33) modulo P à incrément unité, un accumulateur (30) modulo P, à incrément K, cadencé à la fréquence de l'oscillateur de référence (2), une mémoire d'incrément K (32) qui reçoit un ordre d'écriture d'une sortie de débordement du compteur (33) modulo P à incrément unité et qui est connectée en sortie lecture de données à une entrée d'incrément de l'accumulateur (30) modulo P à incrément K, et un moyen de synchronisation (31) synchronisant le signal de débordement de l'accumulateur (30) avec le signal de sortie du compteur-diviseur (5) avant de l'appliquer au compteur-diviseur (5) en tant que commande de changement de rang de division.

7. Synthétiseur selon la revendication 6, caractérisé en ce que la dite mémoire d'incrément (32) comporte un multiplexeur (320) avec une sortie de données, une entrée d'adressage connectée à la sortie de débordement du compteur (33) modulo P par l'intermédiaire d'une bascule logique de type D (34) cadencée par l'oscillateur de référence (2) et avec deux entrées de données dont l'une est rebouclée sur sa sortie de données par l'intermédiaire d'une bascule de type D (321) cadencée par l'oscillateur de référence (2).

8. Synthétiseur selon la revendication 6, caractérisé en ce que ledit accumulateur (30) modulo P à une entrée de commande de remise à zéro connectée à la sortie de débordement du compteur modulo P (33) par l'intermédiaire d'une bascule logique de type D (34) cadencée par l'oscillateur de référence (2).

9. Synthétiseur selon la revendication 6, à pas fractionnaires multiples avec, dans sa boucle de phase, un compteur-diviseur (5) à s rangs entiers successifs de division N, N+1,..., N+s et, pour la commande du rang instantané de division dudit compteur-diviseur (5), un circuit de commande de rang instantané de division effectuant, en parallèle, au rythme de l'oscillateur de référence (2), s accumulations numériques, selon s modulo premiers entre eux $P_1$,.., $P_s$ et avec des incréments entiers variables inférieurs au modulo, et comportant pour ce faire s circuits partiels de calcul implicite d'accumulation numérique et de repérage des débordements de l'accumulation numérique calculée, et un additionneur numérique (40) combinant en sortie les s signaux logiques de repérage de débordement délivrés par les circuits partiels, caractérisé en ce que lesdits circuits partiels de calcul implicite d'accumulation numérique et de repérage des débordement de l'accumulation numérique calculée comportent en commun un compteur (48) opérant au rythme de l'oscillateur de référence (2) selon le produit

$$\prod_{i=1}^{s} P_i$$

des modulo et, chacun en particulier, un accumulateur individuel (41, 42 ou 43) opérant selon un modulo particulier $P_i$, avec un incrément particulier, à la fréquence de l'oscillateur de référence (2) et une mémoire individuelle d'incrément (45, 46 ou 47) qui reçoit un ordre d'écriture de la sortie de débordement du compteur commun (48) et qui est connectée en sortie lecture à une entrée d'incrément de l'accumulateur individuel (41, 42 ou 43).

**Patentansprüche**

1. Kohärenter Frequenzsynthetisierer mit einer Phasenschleife und nicht-ganzzahligem Teilerraster, der einen Bezugsoszillator (2), einen spannungsgesteuerten Oszillator (1) und eine Phasenregelschleife enthält, die das Ausgangssignal des spannungsgesteuerten Oszillators (1) und das das des Bezugsoszillators (2) empfängt und ausgangsseitig die Steuerspannung für den spannungsgesteuerten Oszillator (1) liefert sowie einen Phasenkomparator (4), der einerseits unmittelbar an den Ausgang des Bezugsoszillators (2) und andrerseits an den Ausgang des spannungsgesteuerten Oszillators (1) über einen Zähler-Teiler (5) mit einstellbarem, ganzzahligem Teilerrang angeschlossen ist, wobei der Zähler-Teiler (5) mindestens zwei umschaltbare ganzzahlig aufeinanderfolgende Teilerränge N und N+1 besitzt, und eine Schaltung zur Steuerung des an den Zähler-Teiler (5) angelegten augenblicklichen Teilerrangs enthält, der mindestens eine digitale Akkumulierung modulo P mit ganzzahligem Inkrement K, das justierbar und kleiner als P ist, durchführt und den augenblicklichen Teilerrang abhängig von Überläufen der digitalen Akkumulierung ändert, dadurch gekennzeichnet, daß die Steuerschaltung für den augenblicklichen Teilerrang des Zähler-Teilers (5) mindestens einen Zähler (33, 50) modulo P mit Einheitsinkrement enthält, der von der Frequenz des Bezugsoszillators (2) getaktet wird und als Phasenspeicher verwendet wird, um die Wechsel des Inkrementwerts K der digitalen Akkumulierung nach einem Wechsel des nicht-ganzzahligen Teilerrasters in Zeitpunkten zu veranlassen, die die Phasenreferenz des Ursprungs des digitalen Akkumulierung bezüglich des Ausgangssignals des Bezugsoszillators (2) nicht ändern.

2. Frequenzsynthetisierer nach Anspruch 1, dadurch gekennzeichnet, daß die Schaltung zur Steuerung des augenblicklichen Teilerrangs des Zähler-Teilers (5) außer dem Zähler (50) modulo P mit Einheitsinkrement einen Multiplizierer (51) modulo P, der den Zählerstand des Zählers (50) modulo P mit Einheitsinkrement mit dem Inkrement K der digitalen Akkumulierung multipliziert, einen Komparator (52), der das Ausgangssignal des Multiplizierers (51) modulo P mit dem Inkrement K der digitalen Akkumulierung vergleicht und ein Überlaufsignal immer dann erzeugt, wenn er feststellt, daß das Ausgangssignal des Multiplizierers (51) modulo P eindeutig kleiner als der Wert des Inkrements K der digitalen Akkumulierung ist, und ein Synchronisationsmittel (31) enthält, das das Überlaufsignal des Komparators (52) mit dem Ausgangssignal des Zähler-Teilers (5) synchronisiert, ehe es an den Zähler-Teiler (5) als Steuerung für den Wechsel des Teilerrangs angelegt wird.

3. Frequenzsynthetisierer nach Anspruch 1, dadurch gekennzeichnet, daß die Schaltung zur Steuerung des augenblicklichen Teilerrangs des Zähler-Teilers (5) außer dem Zähler (50) modulo P mit Einheitsinkrement einen Multiplizierer (51) modulo P, der den Zählerstand des Zählers (50) modulo P mit Einheitsinkrement mit dem Inkrement K der digitalen Akkumulierung multipliziert, einen Komparator (52), der das Ausgangssignal des Multiplizierers (51) modulo P mit dem Inkrement K der digitalen Akkumulierung vergleicht und ein Überlaufsignal immer dann erzeugt, wenn er feststellt, daß das Ausgangssignal des Multiplizierers (51) modulo P größer als oder gleich wie die Differenz zwischen dem Wert des Moduls P und dem Inkrement K der digitalen Akkumulierung ist, und ein Synchronisationsmittel (31) enthält, das das Überlaufsignal des Komparators (52) mit dem Ausgangssignal des Zähler-Teilers (5) synchronisiert, ehe es an den Zähler-Teiler (5) zur Steuerung des Wechsels des Teilerrangs angelegt wird.

4. Synthetisierer nach Anspruch 2 oder 3 mit nichtganzzahligen Mehrfachrastern, der in seiner Phasenschleife einen Zähler-Teiler (5) mit s ganzzahligen aufeinanderfolgenden Teilerrängen N, N+1, ..., N+s und zur Steuerung des augenblicklichen Teilerrangs des Zähler-Teilers (5) eine Schaltung zur Steuerung des augenblicklichen Teilerrangs enthält, die parallel im Rhythmus des Bezugsoszillators (2) s digitale Akkumulierungen gemäß s voneinander teilerfremden Moduln $P_1,..., P_s$ und mit ganzzahligen variablen Inkrementen kleiner als der Modul durchführt und hierzu s partielle Schaltungen zur impliziten Berechnung der digitalen Akkumulierung und zur Markierung der Überläufe der berechneten digitalen Akkumulierungen besitzt, sowie einen digitalen Addierer (40), der die s logischen Überlauf-Markiersignale der partiellen Schaltungen ausgangsseitig kombiniert, dadurch gekennzeichnet, daß jede der partiellen Schaltungen zur impliziten Berechnung der digitalen Akkumulierung und zur Markierung der Überläufe der berechneten digitalen Akkumulierung einen individuellen Zähler (60 oder 61 oder 62), der im Rhythmus des Bezugsoszillators (2) gemäß einem eigenen Modul $P_i$ arbeitet, einen eigenen Multiplizierer (63 oder 64 oder 65) gemäß dem besonderen Modul $P_i$ und einen eigenen digitalen Akkumulator (66 oder 67 oder 68) besitzt, der das Ausgangssignal des Multiplizierers modulo $P_i$ mit dem Inkrement der Akkumulierung vergleicht und ein Überlaufsignal abhängig vom Ergebnis des Vergleichs liefert.

5. Synthetisierer nach Anspruch 4 mit nicht-ganzzahligen Mehrfachrastern, wobei seine Regelschleife einen Zähler-Teiler (5) mit drei aufeinanderfolgenden Teilerrängen N, N+1, N+2 und für die Steuerung des augenblicklichen Teilerrrangs des Zähler-Teilers (5) eine Steuerschaltung für den augenblicklichen Teilerrang aufweist, die parallel im Rhythmus des Bezugsoszillators drei digitale Akkumulierungen gemäß drei untereinander teilerfremden Moduln 3, 4 und 5 und mit ganzzahligen variablen Inkrementen durchführt, die kleiner als der Modul sind, dadurch gekennzeichnet, daß der Multiplizierer und der Komparator jeder der partiellen Schaltungen zur impliziten Berechnung der digitalen Akkumulierung und zur Markierung der Überläufe der berechneten digitalen Akkumulierung durch eine Kombination von logischen Toren realisiert sind, die für den Modul 3 dem folgenden logischen Ausdruck

$$\text{MSB}(n_{\text{mod3}}) \cdot \text{LSB}(K) + \overline{\text{LSB}(n_{\text{mod3}})} \cdot \text{MSB}(K),$$

für den Modul 4 dem folgenden logischen Ausdruck

$$\text{MSB}(n_{\text{mod4}}) \cdot \overline{\text{LSB}(n_{\text{mod4}})} \cdot \text{LSB}(K) + \text{LSB}(n_{\text{mod}}4) \cdot \text{MSB}(K)$$

und für den Modul 5 dem folgenden logischen Ausdruck entspricht:

$$\overline{\text{MSB}(n_{\text{mod5}})} \cdot \text{MSB}(K) + \text{LSB}(n_{\text{mod5}}) \cdot \text{ISB}(K) + \text{MSB}(n_{\text{mod5}}) \cdot \text{MSB}(K),$$

wobei n ein Zählerstand der Perioden des Bezugsoszillators (2) seit einem beliebigen Zeitpunkt, K ein digitales Akkumulierungsinkrement, MSB(x) das Bit höchster Gewichtung von x, ISB(x) das Bit mittlerer Gewichtung von x bei einer angenommenen Kodierung mit drei Bits und LSB(x) das Bit geringster Gewichtung von x ist.

6. Synthetisierer nach Anspruch 1, dadurch gekennzeichnet, daß die Schaltung zur Steuerung des augenblicklichen Teilerrangs des Zähler-Teilers (5) außer dem Zähler (33) modulo P und mit Einheitsinkrement einen Akkumulator (30) modulo P mit Inkrement K, der mit der Frequenz des Bezugsoszillators (2) getaktet wird, einen Speicher (32) für das Inkrement K, der einen Schreibbefehl von einem Überlaufausgang des Zählers (33) modulo P mit Einheitsinkrement empfängt und dessen Datenleseausgang an einen Inkrementeingang des Akkumulators (30) modulo P mit Inkrement K angeschlossen ist, und ein Synchronisationsmittel (31) enthält, das das Überlaufsignal des Akkumulators (30) mit dem Ausgangssignal des Zähler-Teilers (5) synchronisiert, ehe es an den Zähler-Teiler (5) als Steuerung für den Wechsel des Teilerrangs angelegt wird.

7. Synthetisierer nach Anspruch 6, dadurch gekennzeichnet, daß der Inkrementspeicher (32) einen Multiplexer (320) mit einem Datenausgang, einem an den Überlaufausgang des Zählers (33) modulo P über eine vom Bezugsoszillator (2) getaktete logische Kippstufe (34) des Typs D und zwei Dateneingänge aufweist, von denen der eine auf den eigenen Datenausgang über eine vom Bezugsoszillator (2) getaktete Kippstufe (321) des Typs D rückgeschleift ist.

8. Synthetisierer nach Anspruch 7, dadurch gekennzeichnet, daß der Akkumulator (30) modulo P einen Nullsetzungs-Steuereingang besitzt, der an den Überlaufausgang des Zählers (33) modulo P über eine vom Bezugsoszillator (2) getaktete logische Kippstufe (34) vom Typ D angeschlossen ist.

9. Synthetisierer nach Anspruch 6 mit nicht-ganzzahligen Mehrfachrastern, der in seiner Phasenschleife einen Zähler-Teiler (5) mit s ganzzahligen aufeinanderfolgenden Teilerrängen N, N+1,..., N+s sowie für die Steuerung des augenblicklichen Teilerrangs des Zähler-Teilers (5) eine Schaltung zur Steuerung des augenblicklichen Teilerrangs besitzt, die parallel im Rhythmus des Bezugsoszillators (2) s digitale Akkumulierungen gemäß s untereinander teilerfremden Moduln $P_1,... P_s$ und mit variablen ganzzahligen Inkrementen kleiner als der Modul durchführt und hierzu s partielle Schaltungen zur impliziten Berechnung der digitalen Akkumulierung und zur Markierung der Überläufe der berechneten digitalen Akkumulierung sowie einen digitalen Addierer (40) aufweist, der die s logischen Signale zur Markierung des Überlaufs, die von den partiellen Schaltungen kommen, kombiniert, dadurch gekennzeichnet, daß die partiellen Schaltungen zur impliziten Berechnung der digitalen Akkumulierung und zur Markierung der Überläufe der berechneten digitalen Akkumulierung alle gemeinsam einen Zähler (48), der im Rhythmus des Bezugsoszillators das Produkt

$$\prod_{i=1}^{s} P_i$$

der Modulwerte und jeweils getrennt einen individuellen Akkumulator (41, 42, 43) aufweisen, der nach einem jeweils eigenen Modul $P_i$ mit einem eigenen Inkrement bei der Frequenz des Bezugsoszillators (2) arbeitet, sowie einen eigenen Inkrementspeicher (45 oder 46 oder 47) enthalten, der einen Schreibbefehl vom Überlaufausgang des gemeinsamen Zählers (48) empfängt und dessen Leseausgang an einen Inkrementeingang des jeweiligen individuellen Akkumulator (41 oder 42 oder 43) angeschlossen ist.

**Claims**

1. Coherent, fractional N-phase locked loop frequency synthesizer, having a reference oscillator (2), a voltage-controlled oscillator (1), an automatic phase control loop which on the input side receives the signal from the voltage-controlled oscillator (1) and the signal from the reference oscillator (2), delivering on the output side the voltage control of the voltage-controlled oscillator (1), and which comprises a phase comparator (4) linked on the one hand directly to the output of the reference oscillator (2) and on the other hand to the output of the voltage-controlled oscillator (1) via a counter-divider (5) with adjustably divisible whole rows, said counter-divider (5) with at least two switchable, N and N+1 divisible, successive whole rows and a circuit for controlling the instantaneous division row applied to the counter-divider (5) carrying out at least one modulo-P digital accumulation, with a whole-number increment K which is adjustable and less than P, and changing said instantaneous division row as a function of the overflows of said digital accumulation, said synthesizer being characterized in that the circuit controlling the instantaneous division row applied to the counter-divider (5) has at least one unit-incremented modulo-P counter (33, 50) set to the frequency of the signal from the reference oscillator (2) and used in phase memory to assign the changes in value of the digital accumulation increment K following on from changes in the fractional division ratio, to points in time not modifying the phase reference of the origin of said digital accumulation with respect to the signal from the reference oscillator (2).

2. Frequency synthesizer according to claim 1, characterised in that said circuit for controlling the instantaneous division row of the counter-divider (5) has, in addition to the unit-incremented modulo-P counter (50), a modulo-P multiplier (51) which multiplies the count of the unit-incremented modulo-P counter (50) by the digital accumulation increment K, a comparator (52) which compares the output signal from the modulo-P multiplier (51) with the digital accumulation increment K and generates an overflow signal whenever it finds that the output signal from the modulo-P multiplier (51) is strictly less than the value of the digital accumulation increment K, and a synchronising means (31) which synchronises the overflow signal from the comparator (52) with the output signal from the counter-divider (5) before applying it to the counter-divider (5) as a division row change instruction.

3. Frequency synthesizer according to claim 1, characterised in that said circuit for controlling the instantaneous division row of the counter-divider (5) has, in addition to the unit-incremented modulo-P counter (50), a modulo-P multiplier (51) which multiplies the count of the unit-incremented modulo-P counter (50) by the digital accumulation increment K, a comparator (52) which compares the output signal from the modulo-P multiplier (51) with the digital accumulation increment K and generates an overflow signal whenever it finds that the output signal from the modulo-P multiplier (51) is greater than or equal to the difference between the values of modulo P and of the digital accumulation increment K, and a synchronising means (31) which synchronises the overflow signal from the comparator (52) with the output signal from the counter-divider (5) before applying it to the counter-divider (5) as a division row change instruction.

4. Fractional N-phase synthesizer according to claim 2 or claim 3 with, in its phase loop, a counter-divider (5) having s successive whole division rows N, N+1,..., N+s and, to control the instantaneous division row of said counter-divider (5), an instantaneous division row control circuit which performs, in parallel, s digital accumulations at the rate of the reference oscillator (2), based on s modulos prime among themselves $P_1$, ...., $P_s$ and with variable whole-number increments less than the modulo, and to this end having s implicit computation partial circuits for digital accumulation and identification of the overflows of the computed digital accumulation, and a digital adder (40) which on the output side combines the s overflow identification logic signals delivered by the partial circuits, characterized in that each of said partial circuits for implicit computation of digital accumulation and identification of the overflows of the computed digital accumulation has an individual counter (60, 61 or 62) which operates at the same rate as the reference oscillator (2) based on a specific modulo $P_1$, an individual multiplier (63, 64 or 65) based on the specific modulo $P_i$, and an individual digital comparator (66, 67 or 68) which compares the output signal from the modulo-$P_i$ multiplier with the accumulation increment and delivers an overflow signal as a function of the comparison result.

5. Fractional N-phase synthesizer according to claim 4 with, in its phase loop, a counter-divider (5) having three successive whole division rows N, N+1 and N+2 and, to control the instantaneous division row of said counter-divider (5), an instantaneous division row control circuit which performs, in parallel, three digital accumulations at

**14**

the rate of the reference oscillator (2), based on three modulos 3, 4, 5 prime among themselves and with variable whole increments less than the modulo, characterised in that the multiplier and the comparator of each of said partial circuits for implicitly computing the digital accumulation and identification of the overflows of the computed digital accumulation are obtained with the help of a combination of logic gates which in respect of modulo 3 satisfies the following logic equation:

$$MSB(n \bmod 3).LSB(K) + \overline{LSB(n \bmod 3)}. MSB(K)$$

and in respect of modulo 4 satisfies the logic equation:

$$MSB(n \bmod 4).\overline{LSB(n \bmod 4)}.LSB(K) + LSB(n \bmod 4).MSB(K)$$

and in respect of module 5 satisfies the logic equation:

$$\overline{MSB(n \bmod 5)}.MSB(K) + LSB(n \bmod 5).ISB(K) + MSB(n \bmod 5).MSB(K)$$

where n is a count of the periods of the reference oscillator (2) since an arbitrary point in time, K is a digital accumulation increment, MSB(x) is the highest-weighted bit of x, ISB(x) is the supposed average-weighted bit of x encoded over three bits, and LSB(x) is the lowest-weighted bit of x.

6. Synthesizer according to claim 1, characterized in that said instantaneous division row control circuit of the counter-divider (5) has, in addition to the unit-incremented modulo-P counter (33), a K-incremented modulo-P accumulator (30), set to the frequency of the reference oscillator (2), a K increment memory (32) which receives an order to write an overflow output of the unit-incremented modulo-P counter (33) and which is linked on the data-reading output side to an increment input of the K-incremented modulo-P accumulator (30), and a synchronising means (31) which synchronises the overflow signal from the accumulator (30) with the output signal from the counter-divider (5) before applying it to the counter-divider (5) as a division row change instruction.

7. Synthesizer according to claim 6, characterized in that said increment memory (32) has a multiplexer (320) with a data output, an addressing input linked to the overflow output of the modulo P counter (33) via a type D logic flip-flop (34) whose rate is set by the reference oscillator (2) and with two data inputs, one of which is looped back to its data output via a type D flip-flop (321) whose rate is set by the reference oscillator (2).

8. Synthesizer according to claim 6, characterized in that said modulo-P accumulator (30) has a resetting control input linked to the overflow output of the modulo-P counter (33) via a type D logic flip-flop (34) whose rate is set by the reference oscillator (2).

9. Fractional N-phase synthesizer according to claim 6 with, in its phase loop, a counter-divider (5) having s successive whole division rows N, N+1, ..., N+s and, to control the instantaneous division row of said counter-divider (5), an instantaneous division row control circuit which performs, in parallel, s digital accumulations at the rate of the reference oscillator (2), based on s modulos prime among themselves $P_1$ ..., $P_2$ and with variable whole-number increments less than the modulo, and to this end having s implicit computation partial circuits for digital accumulation and identification of the overflows of the computed digital accumulation, and a digital adder (40) which on the output side combines the s overflow identification logic signals delivered by the partial circuits, characterized in that said partial circuits for implicit computation of computed digital accumulation and identification of the computed digital accumulation overflows have in common a counter (48) which operates at the rate of the reference oscillator (2), based on the product

$$\prod_{i=1}^{s} P_i$$

of the modulos and, each specifically, an individual accumulator (41, 42 or 43) which operates based on a specific modulo $P_i$, with a specific increment, at the frequency of the reference oscillator (2) and an individual increment memory (45, 46 or 47) which receives a write order from the overflow output of the common counter (48) and which is linked on the reading output side to an increment input of the individual accumulator (41, 42, or 43).

FIG.1a

FIG.1b

FIG.2a

$F_0 = (N + \frac{K}{P}) F_{ref}$

FIG.2b

FIG.3

FIG.4

EP 0 877 487 B1

FIG.5

FIG.6

FIG.7